# EUROPEAN PATENT APPLICATION

(11) **EP 1 879 223 A1**
(43) Date of publication of application: **16.01.2008**
(21) Application number: 05737202.1
(22) Date of filing: 06.05.2005
(51) Int. Cl.: H01L 21/304

(54) **COMPOSITION FOR COPPER WIRING POLISHING AND METHOD OF POLISHING SURFACE OF SEMICONDUCTOR INTEGRATED CIRCUIT**

(71) Applicant: Asahi Glass Company, Limited, Chiyoda-ku, Tokyo 100-8405 (JP); SEIMI CHEMICAL CO., LTD., Chigasaki-city, Kanagawa, 253-8585 (JP)
(72) Inventor: TSUGITA, Katsuyuki, Seimi Chemical Co., Ltd., Chigasaki-shi Kanagawa, 253-8585 (JP); KAMIYA, Hiroyuki, Asahi Glass Company, Ltd., Yokohama-shi, Kanagawa, 221-8755 (JP)
(74) Representative: Müller-Boré & Partner Patentanwälte
(86) International application number: PCT/JP2005/008366
(87) International publication number: WO 2006/120727

(57) **Abstract**

To provide a technique for realizing high-precision surface planarization when copper is used as a wiring metal.

A polishing compound is used which comprises water; a peroxide oxidizer; a surface protective agent for copper; at least one first chelating agent selected from the group consisting of tartaric acid, malonic acid, malic acid, citric acid, maleic acid, oxalic acid and fumaric acid; and at least one second chelating agent selected from the group consisting of triethylenetetramine, ethylenediaminediacetic acid, ethylenediaminetetraacetic acid, tetraethylenepentamine, glycol-ether-diaminetetraacetic acid, trans-1,2-cyclohexanediaminetetraacetic acid, o-phenanthroline, and derivatives thereof.

## Description

### TECHNICAL FIELD

The present invention relates to a polishing compound for copper wirings and a technique to polish a surface of a semiconductor integrated circuit by using such a polishing compound.

### BACKGROUND ART

In recent years, in response to increasing needs for high integration of semiconductor integrated circuits, various micro-fabrication techniques have been developed such as miniaturization of semiconductor elements, multi-layering of wirings, etc.

Multi-layering of wirings is meant for forming by means of e.g. lithography a new circuit on a surface having a circuit already formed. If unevenness is present on the surface of the lower layer circuit, the corresponding unevenness will appear also on the surface on which a new circuit is to be formed and will be out of the depth of focus in lithography, whereby it will be difficult to form a wiring as designed. Accordingly, in designing of semiconductor integrated circuits in recent years, it is required to planarize the circuit-formed surface with an extremely high precision in order to present no influence over the flatness of the surface of the layer to be formed thereon.

For example, in a Damascene method to form a wiring for a circuit simultaneously at the time of planarization of the circuit-formed surface, a trench pattern for the wiring is formed on an objective surface of a semiconductor integrated circuit device, and a metal having a low specific resistance such as aluminum or metallic copper to form the wiring is formed as embedded in such a trench. The metal is firstly formed in the form of a film on the surface by a plating method or a sputtering method, and in many cases, such a film is polished by chemical mechanical polishing (hereinafter referred to as CMP) to remove the metal except for the wiring portion thereby to form a wiring corresponding to the trench. At that time, planarization of the polished surface is simultaneously carried out.

The flatness of this polished surface is important in order to present no influence over the flatness of the surface of the upper layer, and CMP is an important technique indispensable for preparing highly integrated semiconductor integrated circuits.

However, CMP is known to have problems to be solved, such as a phenomenon so-called dishing wherein the wiring portion is removed to be lower than the planarized surface, a phenomenon so-called erosion wherein, along with high densification of metal wirings, a plurality of closely disposed wirings are scraped off together with a neighboring material such as an insulating material, etc. With respect to dishing and erosion, many means for solution have been proposed (e.g. Patent Document 1), but they have not been fully satisfactory.

Patent Document 1: JP-A-2002-176015 (Claims, Paragraphs 0002-0017)

### DISCLOSURE OF THE INVENTION

### OBJECTS TO BE ACCOMPLISHED BY THE INVENTION

It is an object of the present invention to solve the above problems and to provide a technique for realizing high-precision surface planarization when copper is used as a wiring metal. Other objects and merits of the present invention will be apparent from the following description.

### MEANS TO ACCOMPLISH THE OBJECTS

Embodiment 1 of the present invention provides a polishing compound for copper wirings, which comprises water; a peroxide oxidizer; a surface protective agent for copper; at least one first chelating agent selected from the group consisting of tartaric acid, malonic acid, malic acid, citric acid, maleic acid, oxalic acid and fumaric acid; and at least one second chelating agent selected from the group consisting of triethylenetetramine, ethylenediaminediacetic acid, ethylenediaminetetraacetic acid, tetraethylenepentamine, glycol-ether-diaminetetraacetic acid, trans-1,2-cyclohexanediaminetetraacetic acid, o-phenanthroline, and derivatives and salts thereof.

Embodiment 2 provides a polishing compound for copper wirings, which comprises water; a peroxide oxidizer; a surface protective agent for copper; a chelating agent A having a stability constant of from 2 to 9 as a copper complex; and a chelating agent B having a stability constant of at least 10 as a copper complex.

Embodiment 3 provides the polishing compound for copper wirings according to Embodiment 1, which contains from 0.2 to 20 mass% of the peroxide oxidizer, from 0.001 to 1 mass% of the surface protective agent for copper, from 0.1 to 10 mass% of the first chelating agent, and from 0.01 to 2 mass% of the second chelating agent.

Embodiment 4 provides the polishing compound for copper wirings according to Embodiment 1 or 3, wherein the compositional ratio (the mass ratio) of the first chelating agent to the second chelating agent is within a range of from 2/1 to 100/1.

Embodiment 5 provides the polishing compound for copper wirings according to Embodiment 2, which contains from 0.2 to 20 mass% of the peroxide oxidizer, from 0.001 to 1 mass% of the surface protective agent for copper, from 0.1 to 10 mass% of the chelating agent A, and from 0.01 to 2 mass% of the chelating agent B.

Embodiment 6 provides the polishing compound for copper wirings according to Embodiment 2 or 5, wherein the compositional ratio (the mass ratio) of the chelating agent A to the chelating agent B is within a range of from 2/1 to 100/1.

Embodiment 7 provides the polishing compound for copper wirings according to any one of Embodiments 1 to 6, wherein the peroxide oxidizer is hydrogen peroxide.

Embodiment 8 provides the polishing compound for copper wirings according to any one of Embodiments 1 to 7, wherein the surface protective agent for copper is a compound having a structure of the formula (1): 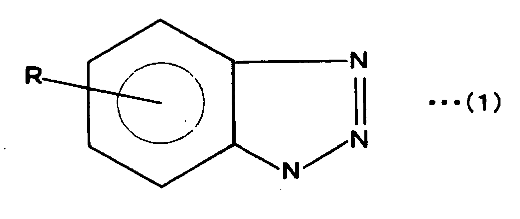 wherein R is a hydrogen atom, a C₁₋₄ alkyl group, a C₁₋₄ alkoxy group or a carboxylic acid group.

Embodiment 9 provides the polishing compound for copper wirings according to any one of Embodiments 1 to 8, which further contains abrasive particles.

Embodiment 10 provides the polishing compound for copper wirings according to Embodiment 9, wherein the abrasive particles have an average particle diameter of from 0.005 to 0.5 µm and a specific surface area within a range of from 30 to 300 m²/g, and their concentration is within a range of from 0.01 to 10 mass%.

Embodiment 11 provides the polishing compound for copper wirings according to any one of Embodiments 1 to 10, which further contains tris(hydroxymethyl)aminomethane in an amount within a range of from 0.01 to 10 mass%.

Embodiment 12 provides a method for polishing a surface of a semiconductor integrated circuit, which comprises polishing a copper film formed on a surface having trenches for wiring, using the polishing compound for copper wirings as defined in any one of Embodiments 1 to 11.

Embodiment 13 provides a process for preparing copper wirings for a semiconductor integrated circuit, which comprises polishing a copper film formed on a surface having trenches for wiring, using the polishing compound for copper wirings as defined in any one of Embodiments 1 to 11, to form copper wirings.

### EFFECTS OF THE INVENTION

According to the present invention, it is possible to realize high precision surface planarization when copper is used as a wiring metal. Therefore, it is possible to obtain a semiconductor integrated circuit having an excellently flat surface state with little dishing and erosion, such being very effective for multi-layering or miniaturization of semiconductor integrated circuits.

### BRIEF DESCRIPTION OF THE DRAWINGS

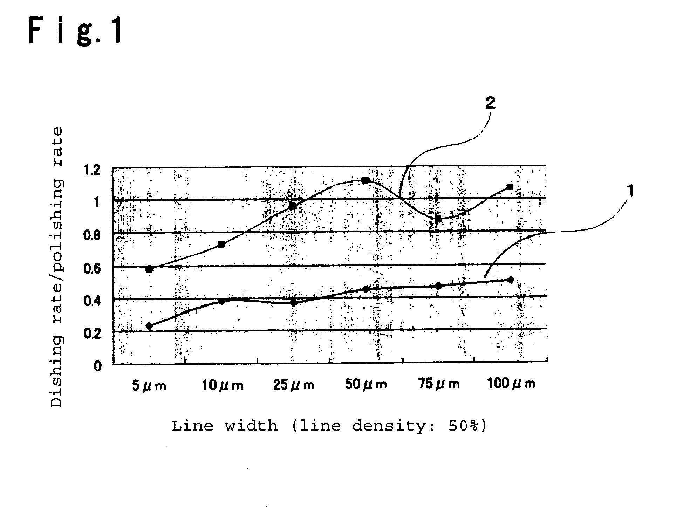

Fig. 1 is a graph showing a relation between dishing rate/polishing rate and the line width.

### MEANINGS OF SYMBOLS

1: Data of Example 1
2: Data of Example 2

### BEST MODE FOR CARRYING OUT THE INVENTION

Now, embodiments of the present invention will be described with reference to formulae, Examples, etc. However, it should be understood that these formulae, Examples, etc. and description are to exemplify the present invention and by no means intended to limit the scope of the present invention. It is needless to say that other embodiments will also belong to the scope of the present invention so long as they agree to the concept of the present invention.

The polishing compound for copper wirings of the present invention comprises the following components:
(1) water;
(2) a peroxide oxidizer;
(3) a surface protective agent for copper;
(4) a chelating agent having a weak coordination power; and
(5) a chelating agent having a strong coordination power.

The function of the polishing compound of the present invention will be described with reference to a case of polishing a copper film on a surface having trenches for wiring of a semiconductor integrated circuit. In the following, the polishing compound of the present invention will be described primarily with respect to a case where it is applied to a semiconductor integrated circuit device having copper wirings, as a particularly preferred application. However, it is needless to say that the polishing composition of the present invention is useful also in other cases so long as it is used for polishing copper wirings.

A peroxide having an oxygen-oxygen bond exhibits a strong oxidizing power when the oxygen-oxygen bond is dissociated by an external energy such as heat or light to generate radicals, and thus, it is widely used as an oxidizing agent. Such a peroxide oxidizer may, for example, be an inorganic peroxide such as hydrogen peroxide, a persulfate, sodium peroxide, a peroxocarbonate, a peroxosulfate or a peroxophosphate, or an organic peroxide such as benzoyl peroxide, t-butyl hydroperoxide, cumene hydroperoxide, diisopropylbenzene hydroperoxide, performic acid or peracetic acid.

Such a peroxide is also known to react with a reducing agent such as a transition metal compound to rapidly form radicals, and as such a typical reaction, a Fenton reaction represented by the following formulae is well-known.

2Cu²⁺ + H₂O₂ → 2Cu⁺ + 2H⁺ + O₂

Cu⁺ + H₂O₂ → · OH + OH⁻ + Cu²⁺

When, for example, a copper film on a surface of a semiconductor integrated circuit having trenches for wiring, is polished with an aqueous polishing compound containing a peroxide oxidizer, by the action of the peroxide oxidizer incorporated in the polishing composition, radicals will be formed by a reaction mechanism similar to the above mentioned Fenton reaction and will serve as a strong oxidizing agent to oxidize and destroy the copper film, whereby polishing will proceed at a high removal rate (hereinafter such a radical-forming reaction will be referred to as a Fenton reaction-type radical-forming reaction).

However, if polishing continues to proceed by such a Fenton reaction type radical-forming reaction, the copper wirings formed on the surface will also be polished, thus leading to a phenomenon so-called dishing and erosion.

With the polishing compound of the present invention, it is possible to suppress the Fenton reaction type radical-forming reaction thereby to suppress formation of radicals and suppress the progress of polishing of copper at the time when copper wirings have been formed on the surface, whereby progress of polishing of copper can be prevented without excessively polishing the wirings.

Thus, according to the present invention, when copper is used as a wiring metal, it is possible to realize high precision surface planarization while a high removal rate is maintained without excessively polishing the copper wirings. Therefore, it is possible to obtain a semiconductor integrated circuit surface having an excellently flat surface condition, which is very effective for multi-layering or miniaturization of semiconductor integrated circuits.

### FUNCTION OF CHELATING AGENT HAVING WEAK COORDINATION POWER

In order to let the above Fenton reaction-type radical-forming reaction proceed effectively, it is undesirable that copper once freed during the polishing will again deposit or precipitate. Therefore, it is preferred that copper ions freed during the polishing be chelated.

However, in the Fenton reaction type radical-forming reaction, copper freed by the polishing is employed to accelerate the polishing, hence it should be avoided that the chelating be proceeded too much to supply copper required for the Fenton reaction type radical-forming reaction. Therefore, as the chelating agent to be used, one is preferred which is capable of supplying copper for the Fenton reaction type radical-forming reaction required for the polishing step, while copper freed by the polishing be chelated. For this purpose, in the present invention, one having a weak coordination power with copper ions, is selected for use.

The chelating agent having a weak coordination power to be used in the present invention may, for example, be tartaric acid, malonic acid, malic acid, citric acid, maleic acid, fumaric acid, oxalic acid, triethanolamine, succinic acid, glutaric acid, citraconic acid, itaconic acid, glycolic acid, thioglycolic acid, lactic acid, isocitric acid, gluconic acid, oxalacetic acid, diglycolic acid, thiodiglycolic acid, phthalic acid, salicylaldehyde, sarcosine or quinolinecarboxylic acid, as well as an amino acid such as glycine, alanine, β-alanine, valine, leucine or glycylglycine.

Among them, tartaric acid, malonic acid, malic acid, citric acid, maleic acid, oxalic acid, fumaric acid or triethanolamine, or an amino acid such as glycine, alanine, β-alanine, valine, leucine or glycylglycine, is preferred, and tartaric acid, malonic acid, malic acid, citric acid, maleic acid, oxalic acid or fumaric acid is more preferred. These chelating agents may be used alone or in combination as a mixer of two or more of them.

It is considered that copper coordinated to such a chelating agent having a weak coordination power is not firmly coordinated to the chelating agent or in the form of a copper complex not completely coordinated.

It is considered that such a copper complex will provide copper to the Fenton reaction type radical-forming reaction as being readily freed or as in the coordinated state whereby radicals will be generated in the polishing step to provide a high removal rate to the copper film.

Further, the function of the chelating agent to prevent re-deposition and precipitation on the polished surface of the copper freed during the polishing will appear more effectively in a case where the polishing compound in the polishing environment is acidic or when ammonia, tris(hydroxymethyl)aminomethane, triethanolamine or the like is used for neutralization of the polishing compound.

### FUNCTION OF CHELATING AGENT HAVING STRONG COORDINATION POWER

As the polishing proceeds, the planar copper film is removed, the pattern of copper wirings appears, and copper on the semiconductor integrated circuit surface will be only at the wiring portions. In the present invention, "a copper film" not only means the above mentioned "planar copper film" but may mean a case where it has became a copper wiring pattern.

In such a state, if polishing of copper further progresses, dishing and erosion of the copper wirings will result, whereby planarization can not be attained by polishing of the semiconductor integrated circuit surface. However, if it is possible to suppress the Fenton reaction-type radical-forming reaction at this stage, polishing of the copper wiring surface will be prevented, whereby it is possible to prevent the progress of dishing and erosion of the copper wirings.

In order to suppress the Fenton reaction-type radical-forming reaction in such a manner, it is conceivable to eliminate or substantially reduce copper to be supplied to the Fenton reaction-type radical-forming reaction. As a specific means for this purpose, it is conceivable to incorporate a chelating agent having a strong coordination power with copper, into the polishing compound.

It is considered that by incorporating a chelating agent having a strong coordination power, copper freed by the polishing may be chelated with a strong coordination power, whereby it is possible to prevent the copper from being supplied to the Fenton reaction-type radical-forming reaction thereby to prevent generation of hydroxyl radicals, so that there will be no destruction of copper, and the progress of polishing will be prevented.

Here, the chelating agent having a strong coordination power to be incorporated to the polishing compound may be any agent arbitrarily selected for use as the case requires from the chelating agents so long as it exhibits a strong coordination power with copper ions in the polishing compound or in the polishing environment of the polishing method of the present invention.

The chelating agent having a strong coordination power to be used in the present invention includes, for example, iminodiacetic acid (IDA), nitrilotriacetic acid (NTA), ethylenediaminediacetic acid (EDDA), ethylenediaminetriacetic acid, ethylenediaminetetraacetic acid (EDTA), propylenediamineteteraacetic acid (PDTA), ethylenediaminetetrapropionic acid (EDTP), triaminotriethylamine, ethylenediamine, 1,2-diaminopropane, 1,3-diaminopropane, triaminopropane, diethylenetriamine, triethylenetetramine, tetraethylenepentamine, pentaethylenehexamine, glycol ether diaminetetraacetic acid (EGTA), trans-1,2-cyclohexanediaminetetraacetic acid (CyDTA), diethylenetriaminepentaacetic acid (DTPA), 2-hydroxyethylethylenediaminetriacetic acid (HEDTA), o-phenanthroline, thiourea, 2,2-bipyridyl, cysteine, and their derivatives and salts. Among them, triethylenetetramine, ethylenediaminediacetic acid, ethylenediaminetetraacetic acid, tetraethylenepentamine, glycol ether diaminetetraacetic acid, trans-1,2-cyclohexanediaminetetraacetic acid, o-phenanthroline, or their derivatives or their salts are preferred. They may be used alone or in combination as a mixture of two or more of them.

### FUNCTION OF THE COMBINATION OF CHELATING AGENT HAVING WEAK COORDINATION POWER AND CHELATING AGENT HAVING STRONG COORDINATION POWER

As described above, after the copper wiring pattern has appeared, the function of the chelating agent having a strong coordination power will be important, and the function of the chelating agent having a weak coordination power is not required. However, in polishing of a planar copper film, use of a chelating agent having a weak coordination power is important to suppress re-deposition and precipitation of free copper while supplying copper necessary for the Fenton reaction-type radical-forming reaction, and the presence of a chelating agent having a strong coordination power will be a hindrance to such polishing.

Accordingly, the balance of both is important. Namely, in order to maintain a high removal rate in the polishing of a planar copper film and to suppress the removal rate after the copper wirings have been formed, it is important to use a combination of a chelating agent having a weak coordination power and a chelating agent having a strong coordination power.

### QUANTITATIVE RELATION BETWEEN CHELATING AGENT HAVING WEAK COORDINATION POWER AND CHELATING AGENT HAVING STRONG COORDINATION POWER

It is considered to be preferred that in order to effectively suppress the Fenton reaction type radical-forming reaction after copper wirings have been formed, the amount of the chelating agent having a strong coordination power is an amount sufficient to form a complex with all or substantially all of copper which will be freed by polishing after the copper wirings have been formed, and at the time of polishing a planar copper film, the blend amounts and the compositional ratio of the chelating agent having a weak coordination power and the chelating agent having a strong coordination power are such that the Fenton reaction type radical-forming reaction will not thereby be hindered.

It is considered that in the polishing mechanism employing a polishing compound having the amounts of the respective chelating agents adjusted as described above, the polishing will proceed, and copper wirings will be formed, as follows.

In a step where a state of a planar copper film formed over the entire surface of a semiconductor integrated circuit is polished, a large amount of copper will be freed at the time of polishing, whereby copper may be present in an amount more than the amount which will be made to be a copper complex by the chelating agent having a strong coordination power. The rest of free copper other than one which became a copper complex by the chelating agent having a strong coordination power, will be coordinated to the chelating agent having a weak coordination power. The copper complex having such a weak coordination power is considered to provide the coordinated copper to the Fenton reaction-type radical-forming reaction to generate radicals thereby to accelerate the polishing.

As the polishing progresses and copper wirings are formed on the surface, the amount of copper freed by polishing decreases. This is natural, since the sum of the surface areas of the copper wirings is small as compared with the surface area of the planar copper film. Therefore, substantially all of copper freed at this stage will preferentially be coordinated to the chelating agent having a strong coordination power, and it is made possible that there will be substantially no copper which is coordinated to the chelating agent having a weak coordination power. Consequently, the Fenton reaction-type radical-forming reaction tends to hardly take place, the progress in polishing by radicals will be hindered, and it is possible to substantially reduce the removal rate of copper.

Namely, the polishing compound for copper wirings of the present invention is preferably one having the compositional ratio of the chelating agent having a weak coordination power and the chelating agent having a strong coordination power adjusted so that at the time of polishing a planar copper film to form copper wirings, polishing of the planar copper film be accelerated, and polishing after formation of the copper wirings be suppressed.

If the amount of the chelating agent having a weak coordination power is small, re-deposition and precipitation of copper freed by polishing will not be suppressed at the time of polishing the planar copper film, and the amount of copper to be supplied from a copper complex to the Fenton reaction-type radical-forming reaction also tends to be insufficient. On the other hand, even if the amount of the chelating agent having a weak coordination power is too much, no further improvement in the effects is expected. Specifically, the amount of the chelating agent having a weak coordination power in the polishing composition of the present invention is preferably from 0.1 to 10 mass%, more preferably from 0.5 to 5 mass%.

If the amount of the chelating agent having a strong coordination power is too small, it tends to be difficult to have all of copper freed by the polishing after the formation of the copper wirings chelated, whereby dishing and erosion of the copper wirings can not be suppressed. On the other hand, if it is too large, copper freed during the polishing of the planar copper film tends to be substantially strongly chelated, whereby the progress of the Fenton reaction-type radical-forming reaction is likely to be hindered. Thus, specifically, the amount of the chelating agent having a strong coordination power in the polishing compound of the present invention is preferably from 0.01 to 2 mass%, more preferably from 0.02 to 0.5 mass%. The compositional ratio of the chelating agent having a weak coordination power to the chelating agent having a strong coordination power (chelating agent having weak coordination power/chelating agent having strong coordination power, mass ratio) is, specifically preferably within a range of from 2/1 to 100/1, more preferably within a range of from 10/1 to 50/1.

By a study of the polishing rate and the dishing rate as described hereinafter, it is possible to grasp whether or not in the present invention, polishing of a planar copper film is accelerated, and polishing after formation of the copper wirings is suppressed, as desired. By such a study, it is possible to determine the blend amounts and compositional ratio of the chelating agent having a weak coordination power and the chelating agent having a strong coordination power.

Further, from another viewpoint, the polishing compound for copper wirings of the present invention may be regarded as a polishing compound for copper wirings, which comprises water; a peroxide oxidizer; a surface protective agent for copper; a chelating agent A having a stability constant of from 2 to 9 as a copper complex; and a chelating agent B having a stability constant of at least 10 as a copper complex. If the composition departs from this range, it tends to be difficult to obtain the effects of the present invention i.e. to suppress the removal rate after formation of copper wirings while maintaining a high removal rate in polishing of a planar copper film.

The stability constant of a copper complex can be measured by pH titration using a glass electrode by a method disclosed by Bjerrum, J., "Metal Ammine Formation in Aqeuous Solution", Haase & Son, Copenhagen (1957), Schwarzenbach, G., Helv. Chem. Acta 33, 947 (1950) and Callahan, C. M., et al, Anal. Chim. Acta 16, 101 (1957). Further, it can be simply searched in SC-Database provided by Stability Constant Committee of UPAC.

Here, the stability constant of a complex constituted by a chelating agent and copper is considered to be an index showing the strength/weakness of the coordination power. Usually, a chelating agent has a large coordination power as the stability constant is large. Accordingly, it is considered that as a chelate having a weak coordination power, a chelating agent having a low stability constant be used, and as a chelate having a high coordination power, a chelating agent having a high stability constant be used, and Embodiment 2 of the present invention has been accomplished on this basis.

The stability constant of the chelating agent A is from 2 to 9, preferably from 3 to 7. The stability constant of the chelating agent B is at least 10, preferably at least 13. If the stability constant of the chelating agent A is less than 2, the formed copper complex tends to hardly prevent re-deposition of copper freed during the polishing, and if it exceeds 9, a sufficient amount of copper ions tends to be hardly supplied from the copper complex to the Fenton reaction-type radical-forming reaction, and a high removal rate tends to be hardly obtainable. Further, if the stability constant of the chelating agent B is less than 10, it tends to be difficult to maintain the copper complex as it is without supplying freed copper to the Fenton reaction-type radical forming reaction.

So long as the above relation relating to the stability constants is satisfied, selection of materials for chelating agents A and B is free. In such a case, the amount of the chelating agent A in the polishing compound of the present invention is preferably from 0.1 to 10 mass%, more preferably from 0.5 to 5 mass%. Further, the amount of the chelating agent B in the polishing compound is preferably from 0.01 to 2 mass%, more preferably from 0.02 to 0.5 mass%. The compositional ratio of the chelating agent A to the chelating agent B (chelating agent A/chelating agent B, mass ratio) is specifically preferably within a range of from 2/1 to 100/1, more preferably within a range of from 10/1 to 50/1.

The combination of the chelating agent A and the chelating agent B may be selected among the above mentioned combinations of the chelating agent having a weak coordination power and the chelating agent having a strong coordination power. In such a case, various preferred embodiments as described above with respect to the polishing composition for copper wirings containing a combination of a chelating agent having a weak coordination power and a chelating agent having a strong coordination power may, of course, be applicable also to the polishing compound for copper wirings containing such a combination of the chelating agent A and the chelating agent B.

As preferred examples of the chelating agent A, the above mentioned preferred examples of the chelating agent having a weak coordination power may be mentioned, and as preferred examples of the chelating agent B, the above mentioned preferred examples of the chelating agent having a strong coordination power may be mentioned. Now, with respect to the preferred examples of the chelating agent A and the preferred examples of the chelating agent B, specific numerical values for the stability constants will be shown.

### PREFERRED EXAMPLES OF CHELATING AGENT A (THE NUMERICAL VALUES IN BRACKETS REPRESENT THE STABILITY CONSTANTS)

Tartaric acid (3.2), malonic acid (4.9), malic acid (3.3), citric acid (4.5), maleic acid(6.8), oxalic acid (4.5), triethanolamine (4.4), succinic acid (4.3), glutaric acid (2.4), fumaric acid (3.2), citraconic acid (5.0), itaconic acid (3.9), glycolic acid (2.3), lactic acid (4.8), isocitric acid (5.2), gluconic acid (2.4), oxalacetic acid (4.9), diglycolic acid (3.8), thiodiglycolic acid (4.5), phthalic acid (3.1), salicylaldehyde (5.6), sarcosine (7.8), quinolinecarboxylic acid (5.9), an amino acid such as glycine (8.1), alanine (8.1), β-alanine (7.0), valine (8.0), leucine (8.3) or glycylglycine (5.4), or their derivatives or salts.

### PREFERRED EXAMPLES OF CHELATING AGENT B (THE NUMERICAL VALUES IN BRACKETS REPRESENT STABILITY CONSTANTS)

Iminodiacetic acid (IDA) (16.2), nitrilotriacetic acid (NTA) (12.7), ethylenediaminediacetic acid (EDDA) (16.2), ethylenediaminetriacetic acid (16.2), ethylenediaminetetraacetic acid (EDTA) (18.8), propylenediamineteteraacetic acid (PDTA) (18.9), ethylenediaminetetrapropionic acid (EDTP) (14.9), triaminotriethylamine (18.8), ethylenediamine (19.6), 1,2-diaminopropane (19.84), 1,3-diaminopropane (17.17), triaminopropane (20.1), diethylenetriamine (21.3), triethylenetetramine (20.4), tetraethylenepentamine (24.3), pentaethylenehexamine (22.44), glycol ether diaminetetraacetic acid (EGTA) (17), trans-1,2-cyclohexanediaminetetraacetic acid (CyDTA) (21.3), diethylenetriaminepentaacetic acid (DTPA) (20.5), 2-hydroxyethylethylenediaminetriacetic acid (HEDTA) (17.4), o-phenanthroline (21.0), thiourea (15.4), 2,2-bipyridyl (17.0), cysteine (19.4), or their derivatives or salts.

### SURFACE PROTECTIVE AGENT FOR COPPER

It is important to incorporate a surface protective agent for copper to the polishing compound for copper wirings of the present invention. If no surface protective agent is incorporated, destruction of copper by e.g. an oxidizer contained in the polishing compound tends to proceed irrespective of the Fenton reaction-type radical-forming reaction. Therefore, the mechanism of the present invention to adjust the removal rate by controlling the Fenton reaction-type radical-forming reaction tends to hardly work, and it becomes difficult to suppress the removal rate after formation of copper wirings while maintaining a high removal rate in polishing of a planar copper film.

The surface protective agent adsorbed on the copper surface prevents oxidation of the copper surface, but is not so strong as to inhibit oxidation (polishing) of copper by radicals generated in the polishing mechanism of the present invention, and once the Fenton reaction-type radical-forming reaction occurs as in polishing of a planar copper film, this protective film will be broken, and the polishing will proceed. However, it is considered that if no Fenton reaction-type radical-forming reaction occurs by the presence of a chelating agent having a strong coordination power just like after a copper wiring pattern has appeared, this protective film tends to be hardly broken, whereby the polishing will be more suppressed.

The surface protective agent for copper may, for example, be a benzotriazole derivative represented by a compound having a structure of the formula (1), imidazole, an imidazole derivative such as benzimidazole or 2-mercaptobenzimidazole, a tetrazole derivative such as 1H-tetrazole, 5-amino-1H-tetrazole or 5-methyltetrazole, a triazole derivative such as naphthotriazole or 1,2,4-triazole, a thiazole derivative such as 2-aminothiazole or 2-mercaptobenzothiazole or a thiadiazole such as 2-amino-5-mercapto-1,3,4-thiadiazole, as well as indazole, indole, cuprazone, triazine dithiol, thiourea, catechol, salicylaldoxime, pyrazole, 8-hydroxyquinoline or a triphenylmethane derivative. Among them, a compound having the structure of the formula (1), 5-methyltetrazole, thiourea, catechol or salicylaldoxime is preferred, and a compound having a structure of the formula (1) is more preferred.

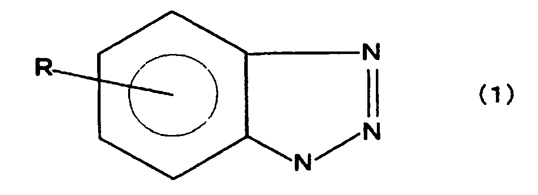

In the formula (1), R is a hydrogen atom, a C₁₋₄ alkyl group, a C₁₋₄ alkoxy group or a carboxylic acid group. More specifically, benzotriazole (BTA), a tolyltriazole having one hydrogen atom at 4- or 5-position of the benzene ring substituted by a methyl group, or a benzotriazole-4-carboxylic acid substituted by a carboxylic acid may, for example, be mentioned. These surface protective agents may be used alone or in combination. The amount of the surface protective agent is preferably from 0.001 mass% to 1 mass%, more preferably from 0.005 to 0.5 mass%, in the polishing compound for copper wirings of the present invention.

### OTHER CONSTITUTING COMPONENTS IN POLISHING COMPOUND

With respect to the peroxide oxidizer to be incorporated to the polishing compound of the present invention, if its amount is too small, the progress of the Fenton reaction-type radical-forming reaction tends to be insufficient, and even if it is too much, the reaction will not proceed. The reason as to why the removal rate decreases when the amount of the peroxide oxidizer is too much, is not clearly understood. However, it is considered that in the polishing, a large amount of oxygen is thereby supplied to the polishing compound, whereby a strong oxide film may be formed on the planar copper film surface, which may hinder the mechanical polishing, or the oxide film formed on the planar copper film surface may hinder the reaction of copper with radicals. The amount of the peroxide oxidizer in the polishing compound of the present invention is preferably from 0.2 to 20 mass%, more preferably from 0.5 to 10 mass%, most preferably from 1 to 5 mass%.

The polishing compound of the present invention can exhibit its effects even when no abrasive particles are incorporated. However, it may, of course, be used together with abrasive particles.

As abrasive particles which can be incorporated to the polishing compound of the present invention or which can be used together with the polishing compound of the present invention, α-alumina, δ-alumina, γ-alumina, fumed silica, colloidal silica or ceria may, for example, be mentioned. Among them, δ-alumina and colloidal silica are preferred from the viewpoint of the dispersibility, stability, abrasive power, etc.

When abrasive particles are incorporated, the average particle diameter of the abrasive particles is preferably from 0.005 to 0.5 µm, more preferably within a range of from 0.01 to 0.3 µm. The specific surface area of the abrasive particles is preferably from 30 to 300 m²/g. If the specific surface area is less than 30 m²/g, the primary particle sizes tend to be too large, and if the specific surface area exceeds 300 m²/g, the primary particle sizes tend to be too small. When the average particle diameter of the abrasive particles is not too small, an adequate removal rate is obtainable, and when the average particle diameter is not too large, a smooth and flat polished surface is obtainable. The concentration of the abrasive particles in the polishing compound of the present invention is preferably from 0.01 to 10 mass%, more preferably from 0.04 to 5 mass%, most preferably from 0.09 to 2 mass%. Such limitations are particularly preferred in a case where δ-alumina and colloidal silica are to be employed.

As other blend materials, ammonia, tris(hydroxymethyl)aminomethane and triethanolamine may, for example, be mentioned. With the polishing compound of the present invention, the function of the chelating agent to prevent re-deposition and precipitation of copper formed during the polishing on a polished surface, appears more effectively in a case where the polishing compound in the polishing environment is acidic or in a case where ammonia, tris(hydroxymethyl)aminomethane, triethanolamine or the like is used for neutralization of the polishing compound. Among them, tris(hydroxymethyl)aminomethane is particularly effective. The concentration of tris(hydroxymethyl)aminomethane is preferably within a range of from 0.01 to 10 mass%, more preferably within a range of from 0.5 to 8 mass%.

With respect to the pH, the pH of the polishing compound to be used in the present invention is preferably from 2 to 10, more preferably from 4 to 9. If the pH is less than 2, corrosion of copper tends to be hardly suppressed, and also when the pH exceeds 10, such is undesirable for the polishing compound of the present invention from the viewpoint of corrosion of copper.

To the polishing compound to be used for the polishing method of the present invention, a surfactant, an oxidizing agent, a reducing agent, a viscosity-controlling agent, a dispersant, an antiseptic, a pH-adjusting agent, etc., may optionally be incorporated in addition to the above composition, unless such incorporation is against the intention of the present invention.

The polishing compound thus constructed is capable of realizing high precision-surface planarization when copper is used as a wiring metal. It is thereby possible to obtain a semiconductor integrated circuit surface having an excellently flat surface condition with little dishing and erosion, such being very effective for multi-layering or miniaturization of semiconductor integrated circuits. More specifically, in a process for producing a semiconductor integrated circuit device by forming copper wirings by a Damascene method, dishing and erosion is effectively prevented, whereby it is possible to obtain a semiconductor integrated circuit surface having an excellently flat surface condition.

The polishing compound for copper wirings of the present invention is suitable for polishing a copper film formed on a surface having trenches for wiring, as a polishing agent. The polishing compound for copper wirings of the present invention may be used as a polishing agent by adding other constituting components thereto. There are many cases wherein it is unnecessary to change the polishing compound or the polishing mechanism depending on the polishing process.

By such polishing, it is possible to form copper wirings having high precision surface flatness with no or little dishing or erosion, and it is possible to realize a semiconductor integrated circuit device having excellent flatness.

### EXAMPLES

Now, Examples of the present invention will be described. Example 1 is a working example of the present invention, and Example 2 is a comparative example.

### EXAMPLE 1

The composition of a polishing compound was as follows.

| | |
|---|---|
| Alumina | 0.1 mass% |
| Tartaric acid (stability constant: 6) | 1 mass% |
| Malonic acid (stability constant: 5) | 1 mass% |
| BTA | 0.03 mass% |
| EDTA (stability constant: 19) | 0.1 mass% |
| Tris(hydroxymethyl)aminomethane | 3.9 mass% |
| Water | the rest |

To 100 parts by mass of the above composition, 5 parts by mass of a 30% hydrogen peroxide aqueous solution was added to finally adjust the proportion of hydrogen peroxide in the polishing compound to be 1.4 mass%. In Examples 1 and 2, the alumina was 5-alumina, and its average particle diameter was 0.013 µm and its specific surface area was 100 m²/g.

With the above polishing compound, polishing was carried out under the following conditions.

### OBJECT TO BE POLISHED

### Blanket Wafer

A 8-inch wafer (000CUR015, manufactured by Sematech) having a 1,500 nm thick Cu layer formed on a Si substrate by wet plating, was used as a wafer for evaluating a copper removal rate.

### Patterned Wafer

A 8-inch water (tradename: 831CMP000, manufactured by Sematech) fabricated by forming wirings having a pattern with a line density of 50% and line widths of 5, 10, 25, 50, 75 and 100 µm on an insulating film made of SiO₂ formed on a Si substrate, forming a 25 nm thick Ta layer by sputtering on the insulating film having such a wiring pattern formed, and further forming a 1,500 nm thick Cu layer thereon by wet plating, was used.

### FILM THICKNESS MEASURING APPARATUS

Using tencor RS-75, manufactured by KLA-Tencor Corporation, the removal rate was measured when the wafer for evaluating the copper removal rate was polished.

### PROFILOMETER

Using tencor HRP-100, manufactured by KLA-Tencor Corporation, the dishing rate of the patterned wiring portions of the patterned wafer was measured.

### POLISHING CONDITIONS

As a polishing machine, a polishing machine Mirra manufactured by Applied Materials Inc. was used.

As a polishing pad, IC-1000 K-Grooved (concentric groove) was used.

The supply amount of the polishing compound was 100 mL/min (which corresponds to 0.049 mL/(min×cm²)).

The polishing pressure was 0.7×10⁴ Pa.

The rotational speed of the polishing pad was such that the head had a rotational speed of 137 revolutions per minute (rpm), and the platen had a rotational speed of 143 rpm.

The results of the polishing under the above polishing conditions are shown in Fig. 1. In the Fig., the polishing rate is the removal rate of the blanket wafer, and for the dishing rate, the removal rate of each line after removal of the planar copper film in the patterned wafer was measured. The polishing rate represents the changing rate of the film thickness, and the dishing rate represents the degree of engraving of the wiring pattern surface from the Ta layer surface by the polishing, i.e. the changing rate of the level from the Ta layer surface. The polishing rate corresponds to a removal rate in a case where the above mentioned planar copper film is polished, and the dishing rate corresponds to a removal rate after the above mentioned copper wirings have been formed.

The dishing rate was measured after polishing for 30 seconds after an excess planar copper film was removed, and the polishing rate is a removal rate when the blanket wafer was polished for 30 seconds.

### EXAMPLE 2

The composition of the polishing compound was as follows.

| | |
|---|---|
| Alumina | 0.1 mass% |
| Tartaric acid (stability constant: 6) | 2 mass% |
| BTA | 0.01 mass% |
| Tris(hydroxymethyl)aminomethane | 4.2 mass% |
| Water | the rest |

To 100 parts by mass of the above composition, 3.3 parts by mass of a 30% hydrogen peroxide aqueous solution was added to finally adjust the proportion of hydrogen peroxide in the polishing compound to be 1 mass%.

With the above polishing compound, polishing was carried out under the same conditions as in Example 1 to obtain the results shown in Fig. 1.

As is evident from the comparison in Fig. 1, in Example 2 wherein no EDTA was incorporated, the ratio of dishing to usual removal rate (dishing rate/polishing rate) is substantially 1 i.e. the polishing speeds being the same at the line widths of at least 25 µm. This means that even if the terminal point of polishing is reached, if the polishing is continued, the removal will proceed with the same removal rate.

Whereas, in Example 1 the dishing rate is substantially one half as compared with the usual removal rate. This means that after reaching the terminal point of polishing, the removal rate of copper decreases. Thus, it is understandable that to the terminal point of polishing of the planar copper film polishing proceeds at a usual removal rate, and when the terminal point of polishing of the planar copper film is passed and the copper wirings are reached, the removal rate of copper automatically decreases, whereby dishing and erosion can be prevented.

### INDUSTRIAL APPLICABILITY

According to the present invention, it is possible to obtain a semiconductor integrated circuit having an excellently flat surface condition, such being very effective for multi-layering or miniaturization of semiconductor integrated circuits.

## Claims

1. A polishing compound for copper wirings, which comprises water; a peroxide oxidizer; a surface protective agent for copper; at least one first chelating agent selected from the group consisting of tartaric acid, malonic acid, malic acid, citric acid, maleic acid, oxalic acid and fumaric acid; and at least one second chelating agent selected from the group consisting of triethylenetetramine, ethylenediaminediacetic acid, ethylenediaminetetraacetic acid, tetraethylenepentamine, glycol-ether-diaminetetraacetic acid, trans-1,2-cyclohexanediaminetetraacetic acid, o-phenanthroline, and derivatives and salts thereof.

2. A polishing compound for copper wirings, which comprises water; a peroxide oxidizer; a surface protective agent for copper; a chelating agent A having a stability constant of from 2 to 9 as a copper complex; and a chelating agent B having a stability constant of at least 10 as a copper complex.

3. The polishing compound for copper wirings according to Claim 1, which contains from 0.2 to 20 mass% of the peroxide oxidizer, from 0.001 to 1 mass% of the surface protective agent for copper, from 0.1 to 10 mass% of the first chelating agent, and from 0.01 to 2 mass% of the second chelating agent.

4. The polishing compound for copper wirings according to Claim 1 or 3, wherein the compositional ratio (the mass ratio) of the first chelating agent to the second chelating agent is within a range of from 2/1 to 100/1.

5. The polishing compound for copper wirings according to Claim 2, which contains from 0.2 to 20 mass% of the peroxide oxidizer, from 0.001 to 1 mass% of the surface protective agent for copper, from 0.1 to 10 mass% of the chelating agent A, and from 0.01 to 2 mass% of the chelating agent B.

6. The polishing compound for copper wirings according to Claim 2 or 5, wherein the compositional ratio (the mass ratio) of the chelating agent A to the chelating agent B is within a range of from 2/1 to 100/1.

7. The polishing compound for copper wirings according to any one of Claims 1 to 6, wherein the peroxide oxidizer is hydrogen peroxide.

8. The polishing compound for copper wirings according to any one of Claims 1 to 7, wherein the surface protective agent for copper is a compound having a structure of the formula (1): 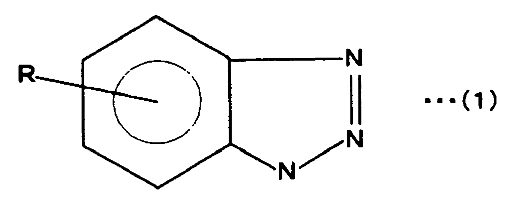 wherein R is a hydrogen atom, a C₁₋₄ alkyl group, a C₁₋₄ alkoxy group or a carboxylic acid group.

9. The polishing compound for copper wirings according to any one of Claims 1 to 8, which further contains abrasive particles.

10. The polishing compound for copper wirings according to Claim 9, wherein the abrasive particles have an average particle diameter of from 0.005 to 0.5 µm and a specific surface area within a range of from 30 to 300 m²/g, and their concentration is within a range of from 0.01 to 10 mass%.

11. The polishing compound for copper wirings according to any one of Claims 1 to 10, which further contains tris(hydroxymethyl)aminomethane in an amount within a range of from 0.01 to 10 mass%.

12. A method for polishing a surface of a semiconductor integrated circuit, which comprises polishing a copper film formed on a surface having trenches for wiring, using the polishing compound for copper wirings as defined in any one of Claims 1 to 11.

13. A process for preparing copper wirings for a semiconductor integrated circuit, which comprises polishing a copper film formed on a surface having trenches for wiring, using the polishing compound for copper wirings as defined in any one of Claims 1 to 11, to form copper wirings.
